# EUROPÄISCHE PATENTSCHRIFT

(11) **EP 3 716 484 B1**
(45) Veröffentlichungstag und Bekanntmachung des Hinweises auf die Patenterteilung: **30.03.2022**
(21) Anmeldenummer: 20155576.0
(22) Anmeldetag: 05.02.2020
(51) Int. Cl.: G06F 3/039, H03K 17/975, H01H 3/02

(54) **FAHRZEUG-BENUTZER-SCHNITTSTELLE**
VEHICLE-USER INTERFACE
INTERFACE UTILISATEUR-VÉHICULE

(30) Priorität: 27.03.2019 DE 102019107843
(43) Veröffentlichungstag der Anmeldung: 30.09.2020
(73) Patentinhaber: Preh GmbH, 97616 Bad Neustadt a. d. Saale (DE)
(72) Erfinder: SCHMIDT, Benedikt, 97650 Fladungen (DE)
(74) Vertreter: Lohmanns, Bernard

(56) Entgegenhaltungen:
- EP-A2- 2 695 923
- DE-A1-102010 010 574
- US-A1- 2018 253 119

## Beschreibung

Die vorliegende Erfindung betrifft eine Fahrzeug-Benutzer-Schnittstelle mit einem Displayglas, das mit einer Folie beschichtet ist und auf dem mindestens ein Betätigungselement angebracht ist, über das Eingaben vorgenommen werden können. Die Erfindung betrifft außerdem ein Fahrzeug mit einer solchen Fahrzeug-Benutzer-Schnittstelle und die Verwendung einer solchen Fahrzeug-Benutzer-Schnittstelle im Fahrzeug.

In der WO 2018/086793 A1 wird eine Fahrzeug-Benutzer-Schnittstelle mit einer berührsensitiven Eingabefläche beschrieben, wobei an der Eingabefläche ein beweglich befestigtes Betätigungselement vorgesehen ist. Durch Sollbruchstellen am Gehäuse der Fahrzeug-Benutzer-Schnittstelle oder am Träger der berührsensitiven Eingabefläche soll das Verletzungsrisiko im Falle eines Kopfaufpralls auf das Betätigungselement verringert werden.

Aus der DE 10 2010 010574 A1 ist eine Fahrzeug-Benutzer-Schnittstelle gemäß dem Oberbegriff des Anspruchs 1 bekannt.

Vor diesem Hintergrund besteht Bedarf nach einer Lösung für eine Fahrzeug-Benutzer-Schnittstelle mit einfacherem Aufbau und im Vergleich verringertem Verletzungsrisiko. Diese Aufgabe wird gelöst durch eine Fahrzeug-Benutzer-Schnittstelle gemäß Patentanspruch 1. Eine gleichermaßen vorteilhafte Verwendung ist Gegenstand des nebengeordneten Verwendungsanspruchs 9.

Vorteilhafte Ausgestaltungen sind jeweils Gegenstand der abhängigen Ansprüche. Die Erfindung betrifft eine Fahrzeug-Benutzer-Schnittstelle, Die Fahrzeug-Benutzer-Schnittstelle im Sinne der Erfindung meint eine Einrichtung zur Vornahme von Steuerungseingaben betreffend das Fahrzeug oder Fahrzeugkomponenten. Als Nutzer, auch Bedienter genannt, wird unter anderem der Fahrer des Fahrzeugs verstanden. Die Fahrzeug-Benutzer-Schnittstelle weist ein Displayglas auf, das mit einer Folie mit mindestens einer Öffnung beschichtet ist. Ein haptisches Betätigungselement ist innerhalb der mindestens einen Öffnung mittels einer ersten Klebeschicht auf dem Displayglas aufgeklebt. Die Klebung ist so, dass eine Betätigung des Betätigungselements über das Displayglas erfassbar ist und im folgenden in einen Eingabebefehl umgesetzt werden kann.

Durch eine solche Verklebung des Betätigungselements direkt auf dem Displayglas können die bei einem Kopfaufschlag auftretenden Kräfte direkt in das Displayglas abgeleitet werden. Dieses bricht bei extremer Belastung, z. B. bei einem Aufprall, und gewährleistet ein Abtauchen des Betätigungselements in die Fahrzeug-Benutzer-Schnittstelle. Das Verletzungsrisiko für den Benutzer wird so vermindert. Durch das direkte Aufkleben des Betätigungselements auf dem Displayglas ohne die Folie als Zwischenlage, ist die Verbindung zwischen Betätigungselement und Displayglas starrer und damit brüchiger und stellt damit eine Art Sollbruchstelle dar. Dies ist im Falle eines Aufpralls erwünscht, da das Betätigungselement bei einem Aufprall in der Fahrzeug-Benutzer-Schnittstelle versenkt werden soll und nicht weiterhin vorstehen soll. Ein weiteres Vorstehen vor das Displayglas könnte möglicherweise zu schwerwiegenderen Verletzungen führen.

Durch das Vorsehen des Betätigungselements kann der Nutzer bei seinen Eingaben unterstützt werden, insbesondere wenn er an herkömmliche Bediengeräte mit beweglich gelagerten Betätigungselementen gewöhnt ist. Außerdem kann dadurch eine Bedienung auch ohne visuelle Kontrolle und ohne Ablenkung vom Verkehrsgeschehen durch Ergreifen des Betätigungselements durchgeführt werden. Neben der über das Displayglas und neben der über das Betätigungselement gegebenen Eingabeoption können weitere Bedienoptionen über weitere Betätigungselemente und/oder weitere Fahrzeugkomponenten vorgesehen sein.

Bevorzugt stellt die Fahrzeug-Benutzer-Schnittstelle eine berührempfindlichen Glasfläche, das Displayglas, zu Verfügung, über den Eingaben vorgenommen werden können. Diese Glasfläche ist in einer Ausgestaltung mit einer Anzeige kombiniert, z. B. einer Pixelmatrixanzeige. Dies wird als Touchscreen bezeichnet. In einer anderen Ausgestaltung handelt es sich um eine anzeigelose Glasfläche, welche als Touchpad bezeichnet werden kann.

Für die Ausgestaltung als Touchscreen oder Touchpad werden auf dem Displayglas vorgenommene Berührungen durch das Displayglas hindurch von einer berührempfindlichen Eingabevorrichtung erfasst. Diese Eingaben erweitern die Möglichkeiten für den Nutzer, Eingaben vorzunehmen. Er kann durch Berührung des Displayglases oder durch Betätigung des Betätigungselementes Eingaben vornehmen. Es ist ebenfalls möglich, ein haptisches Feedback durch das Betätigungselement an den Nutzer vorzusehen.

In der Folie mindestens eine Öffnung für die Klebung des Betätigungselements vorzusehen ermöglicht, die Beschichtung des Displayglases mit der Folie in Gebieten um das Betätigungselement herum und erlaubt so die positiven Eigenschaften der Folie für den für den Benutzer sichtbaren Bereich des Displayglases, Die Öffnung befindet sich unter dem Betätigungselement und das Fehlen der Folie unter dem Betätigungselement ist somit im Normalbetrieb nicht wahrnehmbar im normalen Betrieb. Durch die Öffnung in der Folie ist die Fahrzeug-Benutzer-Schnittstelle zudem einfach aufgebaut und einfach montierbar.

Erfindungsgemäß ist die berührempfindliche Eingabevorrichtung mittels einer zweiten Klebeschicht mit dem Displayglas verklebt. Die zweite Klebeschicht befindet sich auf der von der Folie abgewandten Seite des Displayglases. Die berührempfindliche Eingabevorrichtung kann zur Positionsdetektion des Betätigungselement verwendet werden. Die berührempfindliche Eingabevorrichtung kann beispielsweise auch zur Berührdetektion auf dem Displayglas verwendet werden.

In einer bevorzugten Ausführungsform der Erfindung ist die erste Klebeschicht härter als die zweite Klebeschicht. Damit ist die Klebeverbindung zwischen dem Displayglas und der berührempfindlichen Eingabevorrichtung weicher als die Klebeverbindung zwischen dem mechanischen Betätigungselement und dem Displayglas. Dies ermöglicht, dass bei starker Krafteinwirkung auf das Betätigungselement die Kraft unmittelbar an das Displayglas übertragen wird, dieses brechen kann, und das Betätigungselement somit in Richtung Fahrzeug-Benutzer-Schnittstelle abgesenkt wird. Die weiche zweite Klebeschicht ermöglicht und befördert damit ebenfalls das Absenken des Betätigungselementes, All dies vermindert das Verletzungsrisiko für den Nutzer.

In einer Ausführungsform der Erfindung weist die erste Klebeschicht eine Shore Härte D von größer 30, zum Beispiel von größer 35, bevorzugt von größer oder gleich 40 auf. Die Shore Härte ist beispielsweise in Anlehnung an DIN EN ISO 868 definiert. Die erste Klebeschicht besteht dabei beispielsweise aus einem Klebstoff auf der Basis von Acrylaten und härtet unter Einwirkung von Licht und/oder Feuchtigkeit und/oder Wärme aus.

In einer Ausführungsform der Erfindung weist die zweite Klebeschicht eine Shore Härte 00 von kleiner 90, zum Beispiel von kleiner 70, bevorzugt von kleiner 50 auf. Diese Shore Härte ist beispielsweise in Anlehnung an DIN ISO 53505, nach 72 Stunden Härtung bei Raumtemperatur definiert. Beispielsweise besteht die zweite Klebeschicht aus einem Klebstoff auf der Basis von Acrylaten und härtet unter Einwirkung von Licht und/oder Feuchtigkeit und/oder Wärme aus.

Die Fahrzeug-Benutzer-Schnittstelle kann neben dem einen Betätigungselement ein oder mehrere weitere Betätigungselemente aufweisen. Dabei ist das eine oder sind die mehreren weiteren Betätigungselemente ebenfalls wie das mindestens eine Betätigungselement in einer Öffnung der Folie mit dem Displayglas durch die erste Klebeschicht so verklebt, dass eine Betätigung des Betätigungselements über das Displayglas erfassbar ist.

In Ausführungsformen der Erfindung kann eines oder mehrere der Eingabeelemente als Drehsteller ausgebildet sein. Auf diese Weise lässt sich die Eingabe weiter an die jeweiligen Erfordernisse anpassen.

Erfindungsgemäß handelt es sich bei der Folie um einen Splitterschutzfolie und/oder eine Anti-Fingerabdruck-Folie und/oder um eine Anti-Reflexions-Folie. In einer Ausführungsform der Erfindung handelt es sich bei der Folie um eine Folie die alle drei Eigenschaften aufweist. Besonders die Splitterschutzfolie ermöglicht es, dass bei einem Aufprall auf das mechanische Betätigungselement das Betätigungselement in die Displayglas gedrückt wird und das Displayglas infolgedessen zersplittert, es durch die Folie aber verhindert wird, dass Splitter in den Fahrzeuginnenraum gelangen. Die Anti-Reflexion-Folie erhöht den Komfort für den Nutzer, indem sie die Ablesbarkeit des Displays für den Nutzer verbessert. Die Anti-Fingerabdruck-Folie ermöglicht ein sauberes Äußeres der Fahrzeug-Benutzer-Schnittstelle, ohne störende Fingerabdrücke auf dem Displayglas.

In einer Ausführungsform der Erfindung ist die Folie mittels einer dritten Klebeschicht auf dem Displayglas aufgeklebt. Die dritte Klebeschicht kann beispielsweise ebenfalls aus Klebstoff auf der Basis von Acrylaten bestehen.

Weitere Merkmale und Vorteile der Erfindung ergeben sich aus der folgenden Beschreibung von nicht einschränkend zu verstehenden Ausführungsbeispielen der Erfindung, die im Folgenden unter Bezugnahme auf die Figuren näher erläutert wird. In den Figuren bezeichnen gleiche Bezugszeichen gleiche oder gleich wirkende Elemente. Es zeigen schematisch:
- Fig. 1: einen Schnitt durch eine Fahrzeug-Benutzer-Schnittstelle mit einem Bedienelement;
- Fig. 2: ein Fahrzeug mit der Fahrzeug-Benutzer-Schnittstelle.

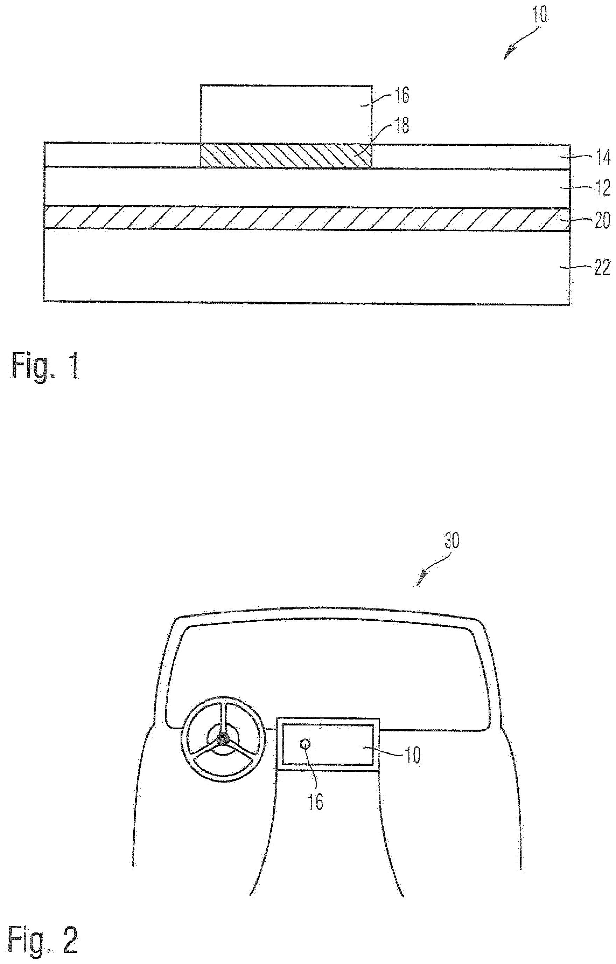

Figur 1 zeigt einen Schnitt durch eine Fahrzeug-Benutzer-Schnittstelle 10 mit einem Displayglas 12 und einer Folie 14. In einer Öffnung der Folie 14 ist ein mechanisches Bedienelement 16 mittels einer ersten Klebeschicht 18 auf das Displayglas 12 aufgeklebt. Auf der von der Folie abgewandten Seite ist das Displayglas 12 über eine zweite Klebeschicht 20 mit einer berührempfindlichen Eingabevorrichtung 22 verklebt. In die berührempfindliche Eingabevorrichtung 22 ist eine kapazitive, resistive und/oder induktive Detektionseinrichtung integriert, durch die die Berührsensitivität realisiert werden kann. Die Fahrzeug-Benutzer-Schnittstelle 10 realisiert einen Touchscreen, der Eingaben eines Nutzers über Berührungen auf dem Displayglas 12 erkennen kann. Zusätzlich können über das mechanische Bedienelement 16 vorgenommene Eingaben eines Nutzers erkannt werden. Bevorzugt ist das Bedienelement 16 als Drehsteller realisiert, der drehbar gelagert ist. Das Bedienelement 16 kann außerdem optional durch einen nicht dargestellten Aktor zur Erzeugung eines haptischen Feedbacks motorisch angetrieben werden.

Figur 2 zeigt einen Einblick in das Innere eines Fahrzeuges 30 mit einer Fahrzeug-Benutzer-Schnittstelle 10 mit einem Bedienelement 16. Besonders in Fahrzeugen sind die Anforderungen hoch, Aufprallschutz zu gewährleisten und das Verletzungsrisiko bei einem möglichen Unfall möglichst gering zu halten. Insbesondere bei einem Kopfaufprall auf der Fahrzeug-Benutzer-Schnittstelle ist es anzustreben, dass die Fahrzeug-Benutzer-Schnittstelle nachgibt und die auftretenden Kräfte ins Innere ableitet und so die auf den Kopf wirkenden Kräfte verringert. Dies wird durch die erfindungsgemäße Klebung mittels der ersten Klebeschicht 18 des Betätigungselementes auf das Displayglas 12 erreicht. Die Härte der ersten Klebeschicht 18 ist vergleichsweise hart, insbesondere härter als die Härte der zweiten Klebeschicht 20, gewählt, so dass die Kraft bei einem Aufprall direkt auf das Displayglas 12 wirkt und dieses zum Zersplittern bringt. Durch die aufgebrachte Folie 14 wird dabei ein Eindringen der Splitter in den Innenraum des Fahrzeuges 30 verhindert.

Die hierin offenbarte erfindungsgemäße Anordnung ist nicht auf die hierin offenbarten Ausführungsformen beschränkt, sondern ergibt sich aus dem Schutzumfang der Patentansprüche.

### Bezugszeichenliste

- 10: Fahrzeug-Benutzer-Schnittstelle
- 12: Displayglas
- 14: Folie
- 16: Betätigungselement
- 18: erste Klebeschicht
- 20: zweite Klebeschicht
- 22: berührempfindliche Eingabevorrichtung
- 30: Fahrzeug

## Patentansprüche

1. Fahrzeug-Benutzer-Schnittstelle (10) mit einem Displayglas (12), das mit einer Folie (14) beschichtet ist, und mit mindestens einem an dem Displayglas (12) angebrachten Betätigungselement (16), wobei das Displayglas (12) auf seiner von der Folie (14) abgewandten Seite mittels einer zweiten Klebeschicht (20) mit einer berührempfindlichen Eingabevorrichtung (22) verklebt ist und das Betätigungselement (16) so mittels einer ersten Klebeschicht (18) auf dem Displayglas (12) aufgeklebt ist, dass eine Betätigung des Betätigungselements (16) über das Displayglas (12) mittels der berührempfindlichen Eingabevorrichtung (22) erfassbar ist und, dass die Folie (14) eine Öffnung aufweist, innerhalb derer das Betätigungselement (16) auf das Displayglas (12) aufgeklebt ist, so dass die Folie (14) unter dem Betätigungselement (16) fehlt und sich eine Beschichtung des Displayglases (12) mit der Folie (14) in einem für einen Benutzer sichtbaren, das Betätigungselement (16) umgebenden Bereich ergibt und dass die Folie (14) eine Splitterschutzfolie und/oder eine Anti-Fingerabdruck-Folie und/oder eine Anti-Reflexions-Folie ist.

2. Fahrzeug-Benutzer-Schnittstelle nach Anspruch 1, **dadurch gekennzeichnet, dass** die erste Klebeschicht (18) härter als die zweite Klebeschicht (20) ist.

3. Fahrzeug-Benutzer-Schnittstelle nach einem der vorhergehenden Ansprüche, **dadurch gekennzeichnet, dass** die erste Klebeschicht (18) eine Shore Härte D von größer 30, zum Beispiel von größer 35, bevorzugt von größer oder gleich 40, aufweist.

4. Fahrzeug-Benutzer-Schnittstelle nach einem der Ansprüche 1 bis 3, **dadurch gekennzeichnet, dass** die zweite Klebeschicht (20) eine Shore Härte 00 von kleiner 90, zum Beispiel von kleiner 70, bevorzugt von kleiner 50, aufweist.

5. Fahrzeug-Benutzer-Schnittstelle nach einem der Ansprüche 1 bis 4, **dadurch gekennzeichnet, dass** die erste und/oder zweite Klebeschicht (18, 20) Klebstoff auf Basis von Acrylaten aufweist.

6. Fahrzeug-Benutzer-Schnittstelle nach einem der vorhergehenden Ansprüche, **dadurch gekennzeichnet, dass** das Betätigungselement (16) drehbeweglich gelagert ist.

7. Fahrzeug-Benutzer-Schnittstelle nach einem der vorhergehenden Ansprüche, **dadurch gekennzeichnet, dass** die Folie (14) mittels einer dritten Klebeschicht auf dem Displayglas (12) aufgeklebt ist, wobei die dritte Klebeschicht insbesondere gleich der ersten Klebeschicht sein kann.

8. Fahrzeug (30) mit einer Fahrzeug-Benutzer-Schnittstelle (10) nach einem der vorhergehenden Ansprüche.

9. Verwendung der Fahrzeug-Benutzer-Schnittstelle (10) nach einem der Ansprüche 1 bis 7 in einem Fahrzeug (30).

## Claims

1. Vehicle user interface (10) having a display glass (12), which is coated with a film (14), and having at least one actuating element (16) attached to the display glass (12), wherein that side of the display glass (12) that faces away from the film (14) is adhesively bonded by means of a second adhesive layer (20) to a touch-sensitive input device (22) and the actuating element (16) is adhesively bonded to the display glass (12) by means of a first adhesive layer (18) such that an actuation of the actuating element (16) can be detected via the display glass (12) by means of the touch-sensitive input device (22), and in that the film (14) has an opening, within which the actuating element (16) is adhesively bonded to the display glass (12), with the result that there is no film (14) under the actuating element (16) and the display glass (12) is coated with the film (14) in a region which is visible to the user and surrounds the actuating element (16), and in that the film (14) is an anti-shatter film and/or an anti-fingerprint film and/or an antireflection film.

2. Vehicle user interface according to Claim 1, **characterized in that** the first adhesive layer (18) is harder than the second adhesive layer (20).

3. Vehicle user interface according to either one of the preceding claims, **characterized in that** the first adhesive layer (18) has a Shore D hardness of greater than 30, for example of greater than 35, preferably of greater than or equal to 40.

4. Vehicle user interface according to one of Claims 1 to 3, **characterized in that** the second adhesive layer (20) has a Shore 00 hardness of less than 90, for example of less than 70, preferably of less than 50.

5. Vehicle user interface according to one of Claims 1 to 4, **characterized in that** the first and/or the second adhesive layer (18, 20) comprises an acrylate-based adhesive.

6. Vehicle user interface according to one of the preceding claims, **characterized in that** the actuating element (16) is mounted rotatably.

7. Vehicle user interface according to one of the preceding claims, **characterized in that** the film (14) is adhesively bonded to the display glass (12) by means of a third adhesive layer, wherein the third adhesive layer in particular may be the same as the first adhesive layer.

8. Vehicle (30) having a vehicle user interface (10) according to one of the preceding claims.

9. Use of a vehicle user interface (10) according to one of Claims 1 to 7 in a vehicle (30).

## Revendications

1. Interface véhicule-utilisateur (10) comprenant une vitre d'affichage (12), qui est revêtue d'un film (14), et au moins un élément d'actionnement (16) fixé à la vitre d'affichage (12), un dispositif d'entrée tactile (22) étant collé au moyen d'une deuxième couche adhésive (20) à la vitre d'affichage (12) sur la face de celle-ci qui est opposée au film (14) et l'élément d'actionnement (16) étant ainsi collé à la vitre d'affichage (12) au moyen d'une première couche adhésive (18) de sorte que l'actionnement de l'élément d'actionnement (16) puisse être détecté par le biais de la vitre d'affichage (12) à l'aide du dispositif d'entrée tactile (22), et en ce que le film (14) comporte une ouverture à l'intérieur de laquelle l'élément d'actionnement (16) est collé à la vitre d'affichage (12) de sorte qu'il n'y ait pas de film (14) sous l'élément d'actionnement (16) et la vitre d'affichage (12) soit revêtue du film (14) dans une zone, visible par un utilisateur, qui entoure l'élément d'actionnement (16) et en ce que le film (14) est un film de protection contre les éclats et/ou un film anti-traces de doigts et/ou un film anti-réflexion.

2. Interface véhicule-utilisateur selon la revendication 1, **caractérisée en ce que** la première couche adhésive (18) est plus dure que la deuxième couche adhésive (20).

3. Interface véhicule-utilisateur selon l'une des revendications précédentes, **caractérisée en ce que** la première couche adhésive (18) a une dureté Shore D supérieure à 30, par exemple supérieure à 35, de préférence supérieure ou égale à 40.

4. Interface véhicule-utilisateur selon l'une des revendications 1 à 3, **caractérisée en ce que** la deuxième couche adhésive (20) a une dureté Shore 00 inférieure à 90, par exemple inférieure à 70, de préférence inférieure à 50.

5. Interface utilisateur-véhicule selon l'une des revendications 1 à 4, **caractérisée en ce que** la première et/ou la deuxième couche adhésive (18, 20) comporte de la colle à base d'acrylates.

6. Interface véhicule-utilisateur selon l'une des revendications précédentes, **caractérisée en ce que** l'élément d'actionnement (16) est monté de manière rotative.

7. Interface véhicule-utilisateur selon l'une des revendications précédentes, **caractérisée en ce que** le film (14) est collé sur la vitre d'affichage (12) à l'aide d'une troisième couche adhésive, la troisième couche adhésive pouvant notamment être la même que la première couche adhésive.

8. Véhicule (30) muni d'une interface véhicule-utilisateur (10) selon l'une des revendications précédentes.

9. Utilisation de l'interface véhicule-utilisateur (10) selon l'une des revendications 1 à 7 dans un véhicule (30).
